# DEMANDE DE BREVET EUROPEEN

(11) **EP 1 033 748 A1**
(43) Date de publication de la demande: **06.09.2000**
(21) Numéro de dépôt: 00400496.6
(22) Date de dépôt: 24.02.2000
(51) Int. Cl.: H01L 21/336, H01L 29/10, H01L 21/762

(54) **Nouveau transistor à implantation d'indium dans un alliage SiGe et procédés de fabrication**

(30) Priorité: 01.03.1999 FR 9902513
(71) Demandeur: STMicroelectronics S.A., 94250 Gentilly (FR); FRANCE TELECOM, 75015 Paris (FR)
(72) Inventeur: Skotnicki, Thomas, 38920 Crolles-Montfort (FR); Alieu, Jérôme, 38080 Isle-d'Abeau (FR)
(74) Mandataire: Casalonga, Axel

(57) **Abrégé**

Le nouveau transistor selon l'invention comprend dans une région de canal en silicium, une couche enterrée d'un alliage Si₁₋ₓGeₓ où 10⁻⁵ ≤ x ≤ 4.10⁻¹, de préférence 10⁻⁴ ≤ x ≤ 10⁻¹, dans laquelle est implantée une dose d'indium. La dose d'indium implantée varie de 1.10¹¹ à 4.10¹⁵ atomes/cm², de préférence de 5.10¹² à 5.10¹³ atomes/cm².

Application aux transistors CMOS.

## Description

La présente invention concerne un nouveau transistor à implantation d'indium dans un alliage SiGe ainsi que des procédés pour sa fabrication.

Il est connu que l'implantation d'ions lourds tels que l'indium et l'arsenic dans le canal en silicium de transistors classiques au silicium pour ajuster les tensions de seuil améliore les performances des transistors. Ces dopants permettent en effet de mieux contrôler la chute de la tension de seuil lorsque les dimensions du transistor diminuent (effet canal court), ainsi que la dégradation de la pente sous-le-seuil. De plus, l'indium donne des effets particuliers en ce qui concerne la variation de la tension de seuil sur les transistors longs (habituellement cette tension ne varie pas pour les transistors longs).

L'implantation d'indium dans le silicium du canal présente initialement un profil rétrograde avantageux mais lors des traitements thermiques ultérieurs pour la fabrication du transistor, l'indium implanté diffuse dégradant le profil rétrograde initial. En outre, l'indium s'active mal dans le silicium, c'est-à-dire que le profil de l'indium implanté électriquement actif est très sensiblement différent du profil chimique de l'implantation d'indium.

Il serait donc souhaitable de disposer de transistors ayant des caractéristiques améliorées par rapport aux transistors à implantation d'indium classiques, en particulier en termes de tension de seuil (Vₜₕ), pente sous-le-seuil (S), de l'effet canal court (SCE) et de l'abaissement de la barrière par polarisation du drain (DIBL).

L'invention a donc pour objet un transistor à implantation d'indium ayant un profil d'indium implanté stable rétrograde proche du profil chimique initial de l'indium implanté.

L'invention a aussi pour objet un transistor à implantation d'indium ayant des caractéristiques améliorées par rapport aux transistors de l'art antérieur.

L'invention a aussi pour objet un procédé de fabrication d'un transistor à implantation d'indium tel que défini ci-dessus.

On atteint les buts ci-dessus selon l'invention, en réalisant un transistor à implantation d'indium dont la région de canal en silicium comporte une couche enterrée d'un alliage Si₁₋ₓGeₓ où 10⁻⁵≤x≤4.10⁻¹, de préférence 10⁻⁴ ≤ x ≤ 10⁻¹, dans laquelle est implantée une dose d'indium. La dose d'indium implantée dans la couche d'alliage Si₁₋ₓGeₓ enterrée varie généralement de 1.10¹¹ atomes/cm² à 4.10¹⁵ atomes/cm², et de préférence de 5.10¹² atomes/cm² à 5.10¹³ atomes/cm².

Le transistor selon l'invention défini ci-dessus présente un profil d'implantation d'indium électriquement actif rétrograde stable et très proche du profil chimique d'implantation de l'indium ainsi qu'une amélioration significative des propriétés telles que la tension de seuil, la pente sous-le-seuil, l'effet canal court et l'abaissement de la barrière par polarisation du drain.

L'invention concerne également un premier procédé de fabrication d'un transistor à implantation d'indium tel que défini ci-dessus, qui comprend :
a) la réalisation sur au moins une zone d'une surface d'un substrat de silicium, ladite zone étant destinée à former une région de canal du transistor, d'un film composite multicouches comprenant successivement depuis la surface initiale du substrat au moins une couche d'alliage Si₁₋ₓGeₓ où 10⁻⁵ ≤ x ≤ 4.10⁻¹, de préférence 10⁻⁴ ≤ x ≤ 10⁻¹, et sur cette couche d'alliage Si₁₋ₓGeₓ une couche externe de silicium;
b) l'implantation dans la couche d'alliage Si₁₋ₓGeₓ d'une dose d'indium; et
c) l'achèvement de la fabrication du transistor pour obtenir un transistor dont la région de canal comporte une couche enterrée d'alliage Si₁₋ₓGeₓ dans laquelle est implantée la dose d'indium.

Dans une réalisation préférée du procédé de l'invention, le film composite multicouches est un film composite tri-couches comprenant successivement depuis la surface initiale du substrat une première couche de silicium, une seconde couche d'alliage Si₁₋ₓGeₓ et une troisième couche externe de silicium.

L'épaisseur de la couche d'alliage Si₁₋ₓGeₓ doit être suffisante pour permettre une implantation convenable de l'indium et est généralement de l'ordre de 60 nm.

La couche de silicium, sur la couche d'alliage Si₁₋ₓGeₓ doit avoir une épaisseur au moins égale à 5 nm.

Dans le film composite tri-couches, l'épaisseur de la première couche de silicium n'est pas critique et est en général inférieure à 100 nm.

L'emploi de la couche de silicium externe a pour objet de rendre ce premier procédé compatible avec les étapes du procédé standard de fabrication des transistors, notamment les étapes d'oxydation.

Le film multicouches peut être réalisé de manière classique par épitaxie sélective ou non comme on le décrira ci-après.

Comme cela est bien connu, il est classique de réaliser dans les transistors des tranchées remplies d'un matériau isolant. La gravure des tranchées et leur remplissage avec un matériau isolant, par exemple SiO₂, peut se faire soit après formation du film multicouches, soit avant comme cela sera décrit plus précisément ci-dessous.

L'achèvement du transistor se fait alors en utilisant les étapes classiques du procédé de fabrication standard.

L'invention concerne également un second procédé de fabrication d'un transistor à implantation d'indium tel que défini ci-dessus, qui comprend :
a) l'implantation dans au moins une zone d'un substrat de silicium, ladite zone étant destinée à former une région de canal d'un transistor, d'une dose de germanium pour former dans ladite zone une couche enterrée d'un alliage Si₁₋ₓGeₓ où 10⁻⁵ ≤ x ≤ 4.10⁻¹, de préférence 10⁻⁴ ≤ x ≤ 10⁻¹;
b) l'implantation dans la couche d'alliage Si₁₋ₓGeₓ d'une dose d'indium; et
c) l'achèvement de la fabrication du transistor pour obtenir un transistor ayant une région de canal comportant une couche d'alliage Si₁₋ₓGeₓ dans laquelle est implantée la dose d'indium.

Dans le second procédé, la dose de germanium doit être telle qu'on obtienne une couche Si₁₋ₓGeₓ ayant la composition voulue et l'implantation doit être telle que la couche de Si₁₋ₓGeₓ soit enterrée à une profondeur convenable, c'est-à-dire d'au moins 5 nm.

L'implantation de germanium peut se faire par tout procédé d'implantation classique, permettant d'obtenir la couche Si₁₋ₓGeₓ voulue. Par exemple, l'implantation classique de germanium à des doses de 10¹² atomes/cm² à 10¹⁶ atomes/cm² et des énergies de 20 keV à 300 KeV conviennent pour la réalisation de la couche de Si₁₋ₓGeₓ enterrée selon l'invention.

L'achèvement du transistor, là encore, se fera de manière tout à fait classique.

Dans ce cas également, des tranchées peuvent être gravées et remplies de matériau isolant avant ou après formation de la couche enterrée d'alliage Si₁₋ₓGeₓ.

La suite de la description se réfère aux figures annexées, qui représentent respectivement :
Figure 1 : des graphes du courant de drain (I_{d}) en fonction de la tension de grille (V_{g}) d'un transistor NMOS à implantation d'indium standard et ayant une longueur de grille Lg = 0,11 µm;
Figure 2 : des graphes du courant de drain (I_{d}) en fonction de la tension de grille (V_{g}) d'un transistor NMOS à implantation d'indium dans une couche Si₁₋ₓGeₓ (x = 0,07) selon l'invention et ayant une longueur de grille Lg = 0,11 µm;
Figure 3 : des graphes de la tension de seuil (Vₜₕ) en fonction de la longueur de grille des transistors des figures 1 et 2, respectivement;
Figure 4 : une représentation schématique illustrant la mise en oeuvre du premier procédé de l'invention avec épitaxie non sélective du film tri-couches avant formation de tranchées isolantes;
Figure 5 : une représentation schématique illustrant la mise en oeuvre du premier procédé de l'invention avec épitaxie sélective du film tri-couches après formation de tranchées isolantes;
Figures 6a et 6b : des représentations schématiques illustrant la mise en oeuvre du premier procédé de l'invention avec épitaxie non sélective du film tri-couches après formation de tranchées; et
Figure 7 : une représentation schématique illustrant la mise en oeuvre du second procédé de l'invention.

On a fabriqué deux transistors NMOS à implantation d'indium ayant une largeur de grille de 18 µm et une longueur de grille de 0,11 µm.

Le premier transistor (T1) est un transistor classique à implantation d'indium dans lequel l'indium est implanté dans la région de canal en silicium pur.

Le second transistor (T2) est un transistor à implantation d'indium selon l'invention, dont la couche enterrée d'alliage Si₁₋ₓGeₓ(x = 0,07) a été réalisée selon le premier procédé de l'invention par dépôt épitaxial sélectif d'un film tri-couches Si (50 nm)/Si₁₋ₓGeₓ (60 nm)/Si (10 nm) sur un substrat de silicium.

Pour les deux transistors T1 et T2, l'implantation d'indium a été réalisée classiquement dans les mêmes conditions à une énergie d'implantation de 170 keV et une dose implantée de 10¹³ atomes/cm².

On a comparé les caractéristiques des deux transistors obtenus T1 et T2.

Les résultats sont donnés dans le tableau I ci-dessous.

**TABLEAU I**

| **Caractéristique** | **Transistor T1 (art antérieur)** | **Transistor T2 (invention)** |
|---|---|---|
| Courant de saturation brut (µA/µm) | 890 | 675 |
| | | |
| Tension de seuil linéaire à V_{d} = 0,05V (V) | 0,114 | 0,274 |
| | | |
| Courant à l'état bloqué (A/µm) | 4,9.10⁻⁵ | 5,5.10⁻⁷ |
| | | |
| Courant de saturation normalisé à V_{g} - Vₜₕ = 1,1 V (µA/µm) | 538 | 531 |
| | | |
| Courant de saturation normalisé à V_{off} + 1,5 V (V_{off} tel que I_{d} = 1 nA/µm) (µA/µm) | 460 | 560 |
| | | |
| S à V_{d} fort (1,5 V) (mV/décade) | 386 | 85 |
| | | |
| Effet canal court (SCE + DIBL) (mV) | 526 | 369 |
| | | |
| Effet substrat (V^{1/2}) | 0,042 | 0,111 |
| V_{d} = Tension de drain | | |
| V = Tension de grille | | |
| Vₜₕ = Tension de seuil | | |
| V_{off} = Tension de fuite | | |
| I_{d} = Courant de drain | | |
| ION = Courant d'alimentation | | |
| I_{OFF} = Courant de fuite | | |
| S = Pente sous-le-seuil | | |
| SCE = Effet canal court | | |
| DIBL = Abaissement de la barrière par polarisatin du drain. | | |

Les résultats du tableau I montrent que le transistor T2 selon l'invention, présente des caractéristiques largement améliorées, telles qu'une tension de seuil plus élevée et donc un courant de fuite plus petit, une pente sous-le-seuil plus faible et des effets de petites dimensions (SCE, DIBL) réduits.

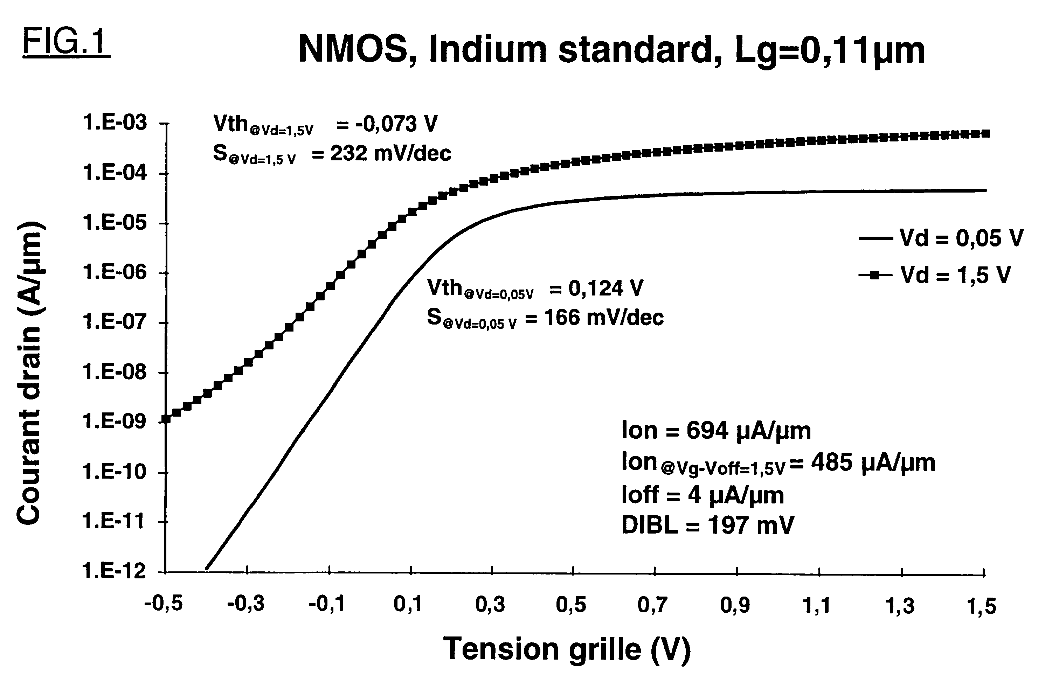

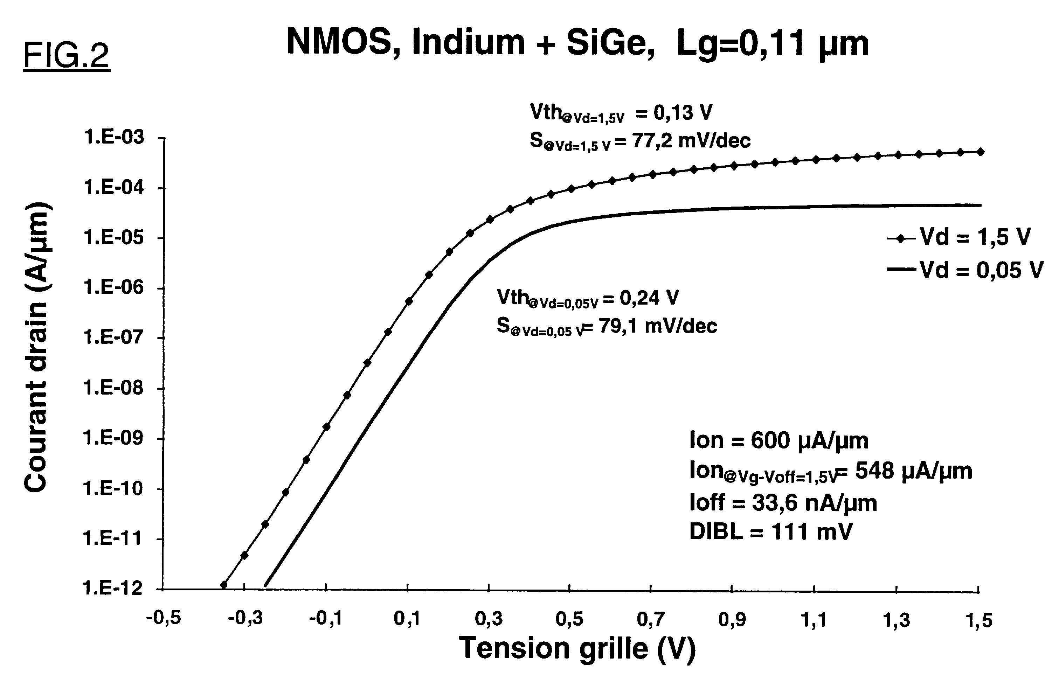

On a représenté pour les deux transistors T1, T2, sur les figures 1 et 2, le courant de drain (I_{d}) en fonction de la tension de grille (V_{g}) pour des tensions de drain (V_{d}) faible et élevée.

Comme le montrent les figures 1 et 2, le transistor T2 présente des pentes sous-le-seuil (S) bien meilleures que le transistor T1, et qui se rapprochent de la valeur idéale de 60 mV/décade.

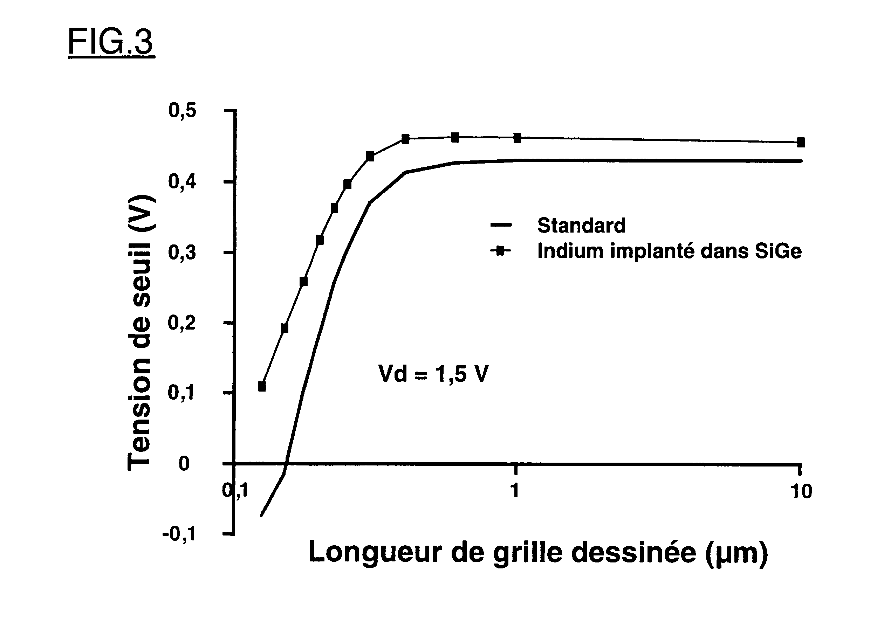

La figure 3, qui est un graphe de la tension seuil (Vₜₕ) en fonction de la longueur de grille pour les deux transistors T1 et T2, montre que l'implantation d'indium dans une couche d'alliage SiGe selon l'invention, conduit à un dopage électriquement actif plus élevé d'où un meilleur contrôle de l'effet canal court.

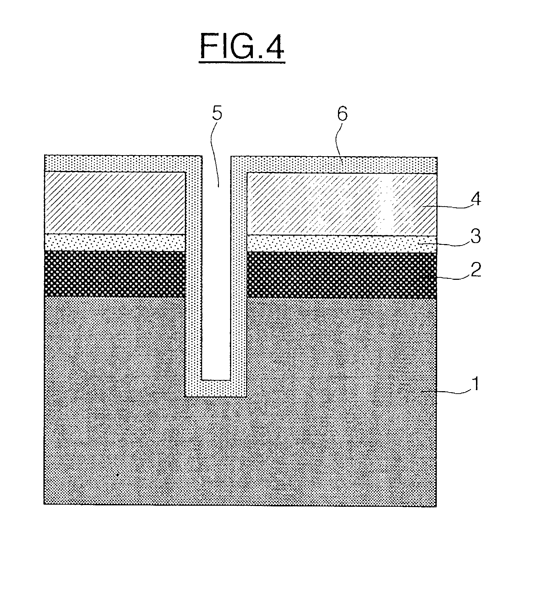

On a représenté schématiquement à la figure 4, une mise en oeuvre du premier procédé de fabrication d'un transistor selon l'invention.

Dans cette mise en oeuvre du premier procédé de l'invention, on commence par déposer par épitaxie non sélective sur la surface d'un substrat 1 en silicium un film tri-couches 2 comprenant une première couche de silicium, une deuxième couche d'alliage Si₁₋ₓGeₓ (10⁻⁵ ≤ x ≤ 4.10⁻¹) et une troisième couche de silicium. Le pourcentage de germanium et l'épaisseur de la couche Si₁₋ₓGeₓ sont choisis de manière à respecter la condition de non relaxation de la contrainte mécanique.

Comme indiqué ci-dessus, les deux couches de silicium permettent de rendre le procédé compatible avec les étapes d'un procédé standard de fabrication d'un transistor, en particulier les étapes d'oxydation. On procède alors à l'implantation d'indium comme décrit précédemment.

On forme ensuite un masque dur, en réalisant de manière classique des couches superposées d'oxyde de silicium 3 et de nitrure de silicium 4 et en photolithographiant ces deux couches.

On procède alors à la gravure, par tout procédé classique, de la tranchée 5.

On peut alors procéder classiquement au remplissage de la tranchée 5 avec un matériau isolant tel que SiO₂ et achever le transistor en utilisant les étapes du procédé standard.

Toutefois, comme le germanium est très réactif vis-à-vis de l'oxygène, il est préférable, avant le remplissage de la tranchée 5 avec du SiO₂, d'isoler celle-ci avec une couche d'un matériau d'encapsulation, tel que par exemple de l'oxynitrure de silicium pour empêcher toute interaction, le SiO₂ remplissant la tranchée et le germanium du film tri-couches.

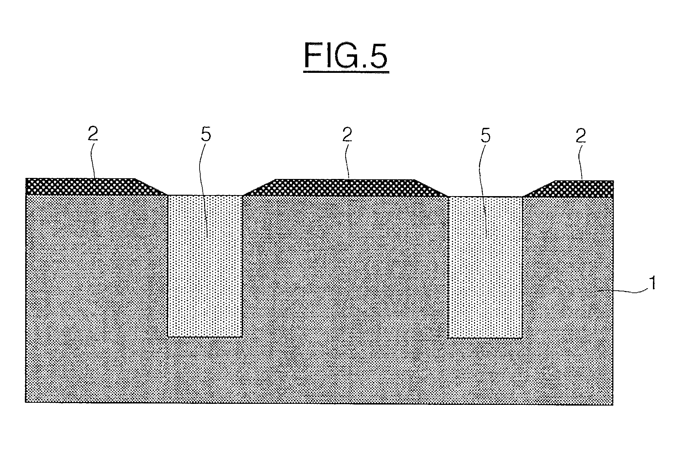

En se référant à la figure 5, on va maintenant décrire une mise en oeuvre du premier procédé de l'invention, avec épitaxie sélective du film tri-couches.

Dans ce cas, on commence par former de manière classique dans le substrat de silicium 1, des tranchées 5 et on les remplit avec un matériau isolant. On dépose alors par épitaxie sélective le film tri-couches 2 selon l'invention. Ainsi, le film tri-couches peut être épitaxié sur des zones actives N et P. Si l'on souhaite une épitaxie sur les seules zones actives N, il faudra alors masquer les zones actives P.

On implante alors de la manière décrite ci-dessus l'indium dans le film tri-couches et on achève le transistor en utilisant le procédé standard.

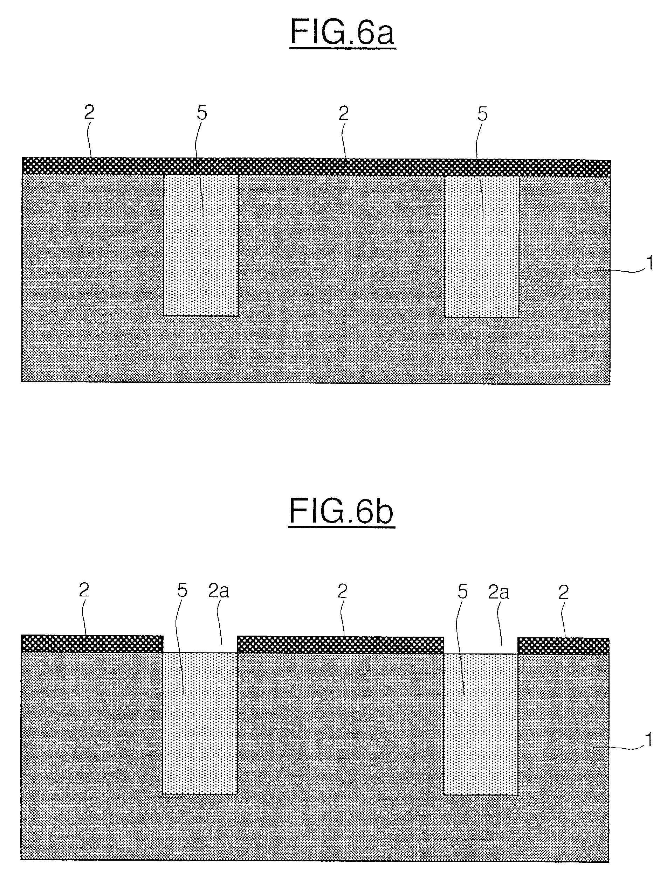

En se référant aux figures 6a et 6b, on va décrire la mise en oeuvre du premier procédé de l'invention avec une épitaxie non sélective du film tri-couches et une formation préalable des tranchées isolantes.

Comme précédemment, le procédé débute par la gravure du substrat 1 pour y former des tranchées 5 qui sont ensuite remplies avec un matériau isolant (SiO₂).

On procède alors au dépôt par épitaxie non sélective d'un film tri-couches 2 continu, c'est-à-dire sur toute la surface. On procède ensuite de manière classique, au moyen d'un masque photolithographié, à la gravure du film tri-couches 2 avec arrêt sur oxyde pour éliminer le film tri-couches 2 correspondant aux tranchées isolantes 5. Puis, on effectue comme décrit précédemment, l'implantation de l'indium et l'achèvement du transistor.

On peut utiliser pour la gravure du film tri-couches 2, le même masque que pour la gravure des tranchées 5.

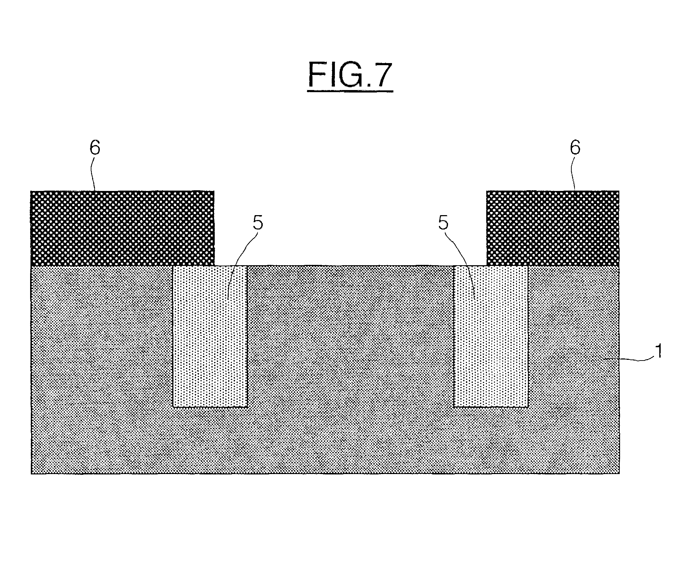

La figure 7 illustre schématiquement une mise en oeuvre du second procédé de l'invention par implantation de germanium dans un substrat de silicium.

Après avoir formé, comme décrit précédemment, des tranchées isolantes 5 dans un substrat de silicium 1, on forme à la surface un masque de résine 6 de motif approprié et on procède comme indiqué ci-dessus à l'implantation de germanium pour former la couche d'alliage Si₁₋ₓGeₓ de l'invention. On procède alors à l'implantation d'indium et à l'achèvement du transistor de manière classique.

Ce dernier procédé a l'avantage d'être simple, rapide et sélectif et de permettre une concentration très faible de germanium.

## Revendications

1. Transistor à implantation d'indium, caractérisé en ce qu'il comprend dans une région de canal en silicium, une couche enterrée d'un alliage Si₁₋ₓGeₓ où 10⁻⁵ ≤ x ≤ 4.10⁻¹, de préférence 10⁻⁴ ≤ x ≤ 10⁻¹, dans laquelle est implantée une dose d'indium.

2. Transistor selon la revendication 1, caractérisé en ce que la dose d'indium implantée varie de 1.10¹¹ à 4.10¹⁵ atomes/cm², de préférence de 5.10¹² à 5.10¹³ atomes/cm².

3. Transistor selon la revendication 1 ou 2, caractérisé en ce que l'indium implanté présente un profil d'implantation électriquement actif, rétrograde, stable, proche du profil d'implantation chimique rétrograde de l'indium.

4. Procédé de fabrication d'un transistor selon l'une quelconque des revendications 1 à 3, caractérisé en ce qu'il comprend :
a) la réalisation sur au moins une zone d'une surface d'un substrat de silicium, ladite zone étant destinée à former une région de canal du transistor, d'un film composite multicouches comprenant successivement depuis la surface initiale du substrat au moins une couche d'alliage Si₁₋ₓGeₓ où 10⁻⁵ ≤ x ≤ 4.10⁻¹, de préférence 10⁻⁴ ≤ x ≤ 10⁻¹, et une couche externe de silicium;
b) l'implantation dans la couche d'alliage Si₁₋ₓGeₓ d'une dose d'indium; et
c) l'achèvement de la fabrication du transistor pour obtenir un transistor dont la région de canal comporte une couche enterrée d'alliage Si₁₋ₓGeₓ dans laquelle est implantée la dose d'indium.

5. Procédé selon la revendication 4, caractérisé en ce que la couche externe de silicium du film multicouches a une épaisseur d'au moins 5 nm.

6. Procédé selon la revendication 4 ou 5, caractérisé en ce que le film composite multicouches est un film tri-couches comprenant en outre une couche de silicium entre la surface initiale du substrat et la couche d'alliage Si₁₋ₓGeₓ.

7. Procédé selon la revendication 4, 5 ou 6, caractérisé en ce que les couches du film composite multicouches sont déposées par épitaxie sélective ou non.

8. Procédé selon l'une quelconque des revendications 4 à 7, caractérisé en ce qu'il comprend avant ou après le dépôt du film composite multicouches la gravure de tranchées d'isolation et le remplissage des tranchées d'isolation avec un matériau isolant.

9. Procédé de fabrication d'un transistor selon l'une quelconque des revendications 1 à 3, caractérisé en ce qu'il comprend :
a) l'implantation dans au moins une zone d'un substrat de silicium, ladite zone étant destinée à former une région de canal d'un transistor, d'une dose de germanium pour former dans ladite zone une couche entourée d'un alliage Si₁₋ₓGeₓ où 10⁻⁵ ≤ x ≤ 4.10⁻¹, de préférence 10⁻⁴ ≤ x ≤ 10⁻¹;
b) l'implantation dans la couche d'alliage Si₁₋ₓGeₓ d'une dose d'indium; et
c) l'achèvement de la fabrication du transistor pour obtenir un transistor ayant une région de canal comportant une couche d'alliage Si₁₋ₓGeₓ dans laquelle est implantée la dose d'indium.

10. Procédé selon la revendication 9, caractérisé en ce que la dose de germanium implantée est de 10¹² à 10¹⁶ atomes/cm².

11. Procédé selon la revendication 10, caractérisé en ce que l'énergie d'implantation du germanium est de 20 à 300 keV.

12. Procédé selon la revendication 10 ou 11, caractérisé en ce qu'il comprend, avant l'implantation du germanium, la gravure dans le substrat de silicium de tranchées d'isolation et le remplissage des tranchées avec un matériau isolant.
